Europäisches Patentamt

European Patent Office

Office européen des brevets

(19)

(11) **EP 0 750 338 B1**

(12) **EUROPEAN PATENT SPECIFICATION**

(45) Date of publication and mention
of the grant of the patent:
**15.01.2003 Bulletin 2003/03**

(51) Int Cl.⁷: **H01L 21/321**, H01L 21/266,
H01L 31/108, H01L 21/336

(21) Application number: **96870078.1**

(22) Date of filing: **19.06.1996**

(54) **Etching process of CoSi2 layers and process for the fabrication of Schottky-barrier detectors using the same**

Ätzverfahren für CoSi2-Schichten und Verfahren zur Herstellung von Schottky-Barrieren Detektoren unter Verwendung desselben

Procédé de gravure de couches de CoSi2 et procédé de fabrication de détecteurs à barrière Schottky utilisant ledit procédé

(84) Designated Contracting States:
**AT BE DE ES FR GB IT NL**

(30) Priority: **19.06.1995 US 2426**

(43) Date of publication of application:
**27.12.1996 Bulletin 1996/52**

(60) Divisional application:
**99200531.4 / 0 923 114**

(73) Proprietor: **INTERUNIVERSITAIR
MICRO-ELEKTRONICA CENTRUM VZW
3001 Heverlee (BE)**

(72) Inventors:
• **Donaton, Ricardo Alves
3001 Heverlee (BE)**
• **Maex, Karen Irma Josef
3020 Herent (BE)**
• **Verbeeck, Rita
3110 Rotselaar (BE)**
• **Jansen, Philippe
2250 Olen (BE)**
• **Rooyackers, Rita
3010 Leuven (BE)**
• **Deferm, Ludo
3581 Beverloo (BE)**
• **Baklanov, Mikhail Rodionovich
3000 Leuven (BE)**

(74) Representative: **Van Malderen, Joelle et al
Office Van Malderen,
Place Reine Fabiola 6/1
1083 Bruxelles (BE)**

(56) References cited:
**GB-A- 2 214 349        US-A- 4 569 722**

• **JOURNAL OF APPLIED PHYSICS, vol. 72, no. 5, 1 September 1992, NEW YORK US, pages 1864-1873, XP000615192 HSIA ET AL: "Resistance and structural stabilities of epitaxial CoSi2 films on (001) Si substrates"**
• **IBM TECHNICAL DISCLOSURE BULLETIN, vol. 30, no. 12, May 1988, NEW YORK US, pages 180-181, XP000124437 "Simplified lightly doped drain process"**
• **IEEE ELECTRON DEVICE LETTERS, vol. 13, no. 4, April 1992, NEW YORK US, pages 174-176, XP000370700 HORI ET AL: "A self-aligned pocket implentation (SPI) technology for 0.2 micrometer dual-gate CMOS"**
• **JOURNAL OF CRYSTAL GROWTH, vol. 127, no. 1/4, February 1993, AMSTERDAM NL, pages 659-662, XP000441158 SCHWARZ ET AL: "Application of epitaxial CoSi2/Si/CoSi2 heterostructures to tunable Schottky-barrier detectors"**
• **IEEE ELECTRON DEVICE LETTERS, vol. 14, no. 4, April 1993, NEW YORK US, pages 199-201, XP000426249 XIAO ET AL: "Silicide/strained SiGe Schottky-barrier infrared detectors"**

**Description**

**Object of the invention**

The present invention is related to an etching process of $CoSi_2$ layers in semiconductor processing.

The present invention is also related to the use of this etching process for the formation of Schottky barrier infrared detectors.

**State of the art**

The use of cobalt disilicide ($CoSi_2$) in microelectronics applications is becoming more and more important. In CMOS technology, with scaling down of dimensions, especially for CMOS technology manufacturing transistor with a gate length smaller than 0.35 µm, $CoSi_2$ has become an attractive material due to its better characteristics when compared to the more frequently used $TiSi_2$.

The interaction of a silicide film with chemicals and reactive gasses during further processing is an important issue to maintain the integrity of the film in the fully integrated structure. $TiSi_2$ is known to be very reactive with chemicals such as $NH_4OH$- and HF-based solutions. $CoSi_2$ is much more robust in that respect. Wet etching of $CoSi_2$ has even been considered very difficult in general.

The document Journal of Applied Physics, vol. 72, nos, pages 1864- 1873, published in September 1992 discloses that $CoSi_2$ is etched in suffered acide etch at a rate of about 5 nm/mn at room temperature.

The document Journal of Crystal fourth, vol. 127, n° 1-4, pages 659-662, published in February 1993 discloses the manufacture of Schottky-barrier infrared detectors using $CoSi_2$ contacts. In this document, $CoSi_2$ is etched with suffered HF.

**Aims of the present invention**

The present invention aims to suggest as a first object an etching process of $CoSi_2$ layers in semiconductor processing which can be accurately controlled.

Furthermore, the present invention aims to suggest the use of the etching process according to the present invention in order to obtain selective etching steps.

A further object of the present invention is to manufacture Schottky barrier infrared detectors which will be improved compared to the ones suggested by the state of the art.

**Main characteristics of the present invention**

The present invention is related to an etching process of $CoSi_2$ layers in semiconductor processing by means of a HF-based solution wherein the etching rate of $CoSi_2$ is controlled by regulating the pH value of the HF-based solution.

The pH of this solution is regulated by adding chemicals to said solution modifying the pH such as $H_2SO_4$ or Hcl in order to reduce the pH or $NH_4OH$ in order to increase the pH of the HF-based solution.

The HF-based solution can be a buffered solution or not.

According to a first preferred embodiment, the pH of the HF-based solution is regulated at a pH comprised between 0 and 1.5 in order to have a rather fast etching rate of the $CoSi_2$ layer.

This particular preferred embodiment will be used in order to have Schottky barrier infrared detectors with $CoSi_2/Si$ or $CoSi_2/Si_{1-x}Ge_x$ interface.

As a first object, the present invention is related to an etching process for $CoSi_2$ layers as defined in claim 1.

As a second object, the present invention is related to process of manufacturing $CoSi_2/Si$ Schottky barrier infrared detectors, preferably $CoSi_2/Si_{1-x}Ge_x$ Schottky barrier infrared detectors comprising the steps of:

- growing a $Si_{1-x}Ge_x$ layer on a silicon substrate;
- growing a Si sacrificial layer on the top of the $Si_{1-x}Ge_x$ layer;
- depositing a Co layer on said Si sacrificial layer;
- heating the Co layer in order to obtain a $CoSi_2$ layer;
- depositing a photoresist strip on said $CoSi_2$ layer;
- developing the photo-resist strip using a masking layer in order to create the required patterning of the $CoSi_2$ layer;
- etching the $CoSi_2$ layer with a HF-based solution having a pH value smaller than 1.5;
- removing the photoresist strip;

### Description of the figures

Figure 1      shows the sheet conductance of $CoSi_2$ layers as a function of etching time in a HF 2wt.% solution.

Figures 2      represent SEM pictures of $CoSi_2$ film (60 nm) surface : a) after 20 s etching; b) after 160 s etching in HF 2%.

Figure 3      represents RBS spectra of $CoSi_2$ film (60 nm) etched for 40, 140 and 200 s in HF 2%.

Figure 4      represents the $CoSi_2$ (60 nm) sheet conductance as a function of etching time for different HF solutions. a function of etching time in HF2%, for different pH values.

Figure 6      represents the concentration of the different species present in a diluted HF solution as a function of its pH.

Figure 7      represents the etch rate of $CoSi_2$ in HF 2% as a function of the pH of the mixture.

Figures 8      are representing schematic views of the several steps of etching $CoSi_2$ layers in order to be used in fabrication of $CoSi_2/Si$ or $CoSi_2/Si_{1-x}Ge_x$ Schottky barrier detectors.

### Detailed description of several embodiments of the present invention

As an example, cobalt silicides are formed on n-type <100> oriented silicon, 125 mm wafers. A standard RCA cleaning followed by an HF dip for hydrogen passivation of the silicon surface were performed just before loading the wafers into the deposition system. Co layers with thickness of 8 nm, 16 nm and 40 nm were deposited using a BALZERS BAS450 DC magnetron sputtering system. The base pressure was always better than $3.0 \times 10^{-4}$ Pa ($3.0 \times 10^{-6}$ mbar). A two-step silicidation process was carried out in an AST rapid thermal processor, in a nitrogen ambient. The temperatures of the first and second annealing steps were 550°C and 700°C, respectively. Between these two annealing steps, a selective etch in a $H_2SO_4/H_2O_2$ solution was done to remove the unreacted metal on top of the silicide.

To investigate the etching rate of $CoSi_2$ in hydrogen fluoride (HF) based solutions, concentrations of 0.5 and 2wt.% of HF were used, as well as a buffered hydrogen fluoride (BHF) solution, which is formed from 1 part of HF 50% and 7 parts of $NH_4F$ 40%. Etching times from 10 seconds to 15 minutes were tested. $H_2SO_4$ or HCl or $NH_4OH$ were added to the solutions to change their pH. The pH values of the solutions were measured with pH paper.

The thinning of the $CoSi_2$ layers was monitored by four point probe sheet resistance measurements (before and after etching). The samples were also characterised by scanning electron microscopy (SEM) and Rutherford backscattering spectroscopy (RBS).

Tables 1 & 2 are summarizing the experimental results obtained.

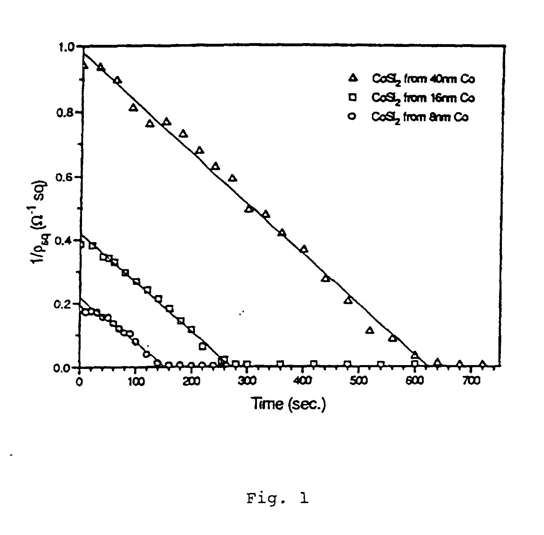

Figure 1 shows the sheet conductance of three different $CoSi_2$ layers as a function of etching time in a HF 2wt.% solution. The thickness of the original $CoSi_2$ layers was 29, 60 and 150 nm resulting in a sheet resistance of 5.5, 2.6 and 1.1 ohm/sq., respectively. For a homogeneous layer the inverse of sheet resistance (sheet conductance) is directly proportional to its thickness. It is clear that the values of the sheet conductance decrease with increasing etch time. This indicates that the $CoSi_2$ film is being attacked by the HF solution. Moreover, the silicide etching rate (determined by the slope of the curve) is constant and independent of the layer thickness. The near-zero values of the sheet conductivity are related to the conductance of the silicon substrate, indicating that the silicide was removed.

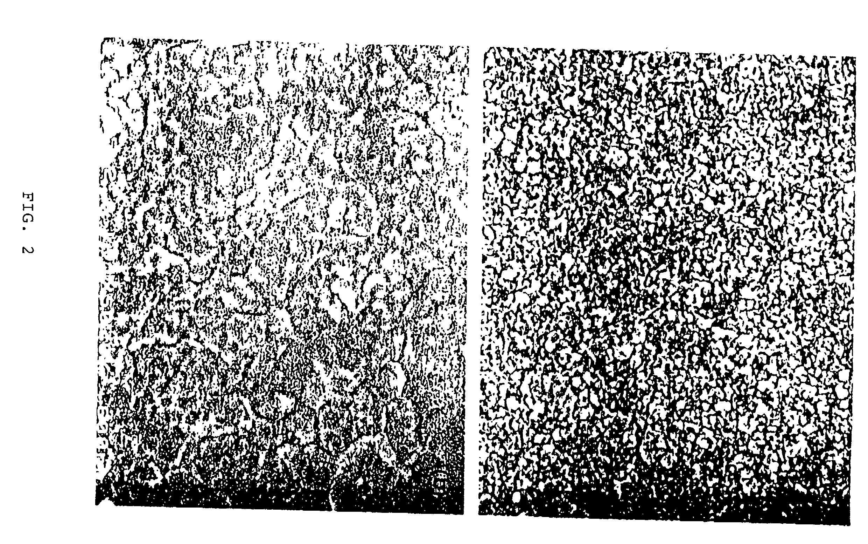

A sequence of SEM pictures taken after different etching times in figure 2 reveal surface morphology changes of the 60 nm $CoSi_2$ film.

Figure 2a shows the $CoSi_2$ layer surface after etching for 20 seconds. In figure 2b the sample was etched for 160 seconds and it is possible to see a delineation of the grain boundaries of the silicide film. It seems that the film is etched a little faster at the grain boundaries. After 300 seconds etching (not shown) the silicide is completely removed and the patterns observed are foot prints of the silicide grains on the silicon substrate surface.

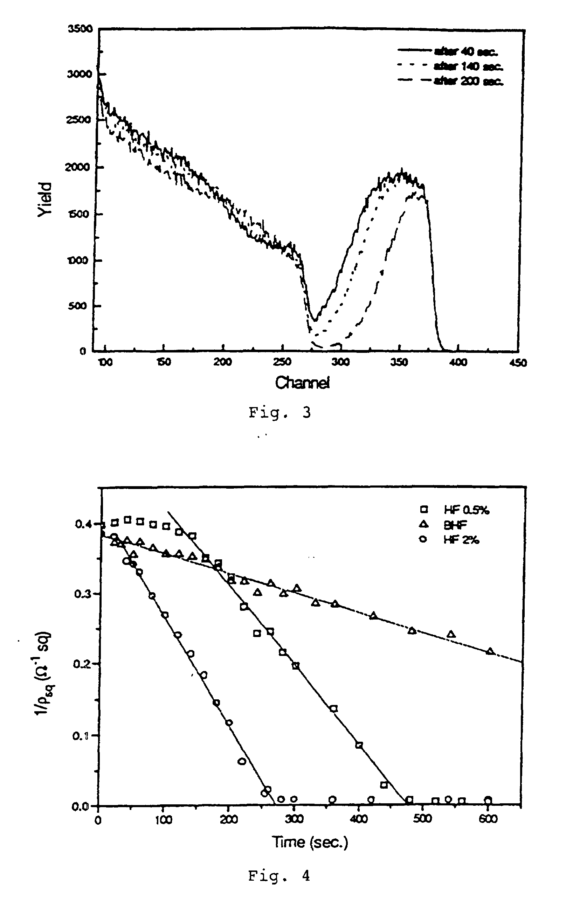

RBS spectra of samples etched for 40, 140 and 200 seconds as represented in figure 3 confirm the thinning of the silicide layers with etch time. These results strongly suggest a layer-by-layer etching mechanism of the $CoSi_2$ film.

Etching of $CoSi_2$ in HF 0.5wt.% and BHF solutions were then investigated. Sheet conductance as a function of etching time is plotted for different HF solutions in figure 4, starting from 60 nm $CoSi_2$. The silicide etch rate is slightly lower for HF 0.5wt.% than for HF 2wt.% solutions. Furthermore, the etching of the silicide layer in HF 0.5% starts after approximately 120 seconds. It is not clear at the moment whether this delay can be attributed to the time necessary to remove the native oxide on the $CoSi_2$. It has also to be considered the concentration of $H^+$ in this solution : initially it is insufficient to start the reaction, but due to an autocatalytic reaction the $H^+$ concentration increases and the silicide can be etched.

When BHF is used the silicide layer is attacked at a significant lower rate than in the case of HF 2%. This is unexpected since from experience of $SiO_2$ etching, BHF is a much stronger etch solution with a significantly higher etch rate than HF 2%. In BHF the most abundant forms of the fluoride are $F^-$ and $HF_2^-$, whereas HF and $H_2F_2$ are more important in HF 2%. This difference in composition yields a lower acid grade for BHF (pH = 4.5) than for a HF 2% solution (pH = 1.5).

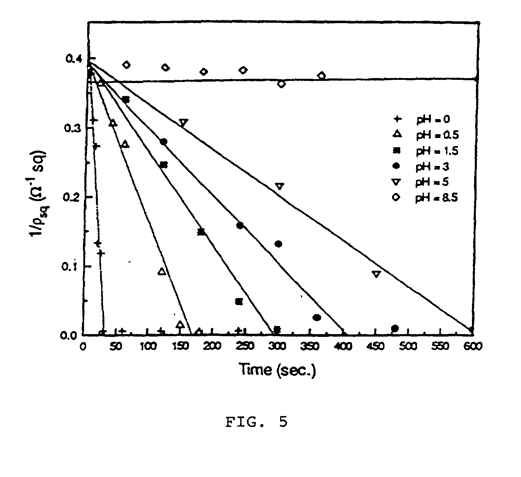

To check out a possible influence of the pH on the etching of $CoSi_2$ in HF solutions, either $H_2SO_4$ or $NH_4OH$ were added to a HF 2% to change its pH from values of near zero to 8.5. Figure 5 represents the sheet conductance values as a function of etch time for 2% HF solutions with varying pH. By forming a more acid solution the etch rate is increased. A 60 nm $CoSi_2$ layer is removed in less than 30 seconds when the pH of the solution is almost zero. On the other hand, the silicide layer does not seem to be attacked for the solution with the highest pH tested (pH = 8.5). It is worth noticing that the sulphuric acid itself does not attack the silicide. In a solution with the same amount of $H_2SO_4$, but no HF, the silicide is not etched at all. The same experiment performed in diluted BHF showed the same trend : solutions with higher pH values etch cobalt silicide films at lower rates than solutions with lower pH values. These results confirm that the etching of $CoSi_2$ in HF based solutions is controlled predominantly by the $H^+$ concentration.

In order to describe quantitatively the $CoSi_2$ etch rate in HF 2%, the concentrations of the different species present in diluted HF solutions were calculated. In these calculations the following equilibria were used:

$$HF = H^+ + F^-$$

$$HF + F^- = HF_2^-$$

$$2HF = H_2F_2$$

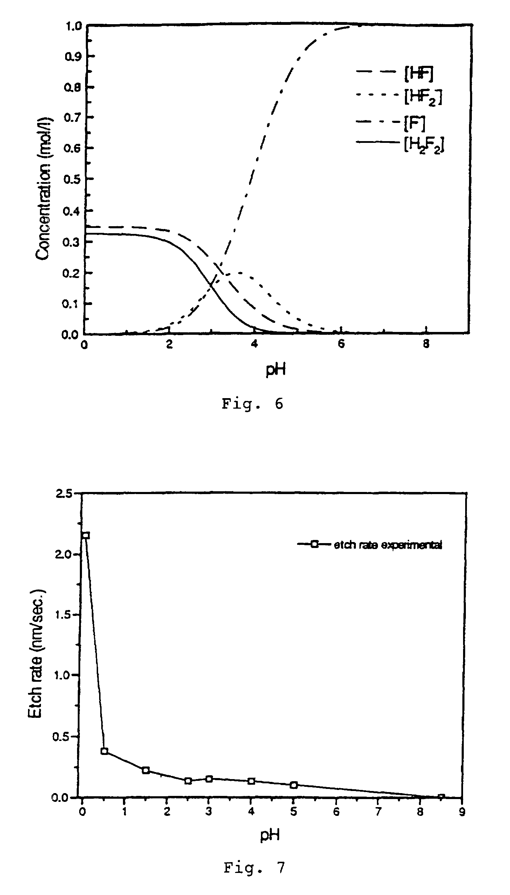

The result is shown in figure 6, where the species concentration is plotted as a function of the pH of the mixture. As can be seen, for low pH values (pH < 1.5) HF and $H_2F_2$ are dominant and their concentrations remain constant. For intermediate pH values the concentrations of $F^-$ and $HF_2^-$ increase and for high pH values the solution is practically formed by $F^-$.

The etch rate (ER) of $CoSi_2$ in HF 2% as a function of the pH of the mixture is plotted in figure 7. In the region where pH < 1.5 the silicide is etched very fast. Since the concentration of all fluoride containing species is constant in this region, $H^+$ plays an important role, being the dominant etching species. Between pH values of 1.5 and 5.5 the etch rate is lower and basically constant, and for pH values higher than 5.5 the silicide seems not to be attacked.

A second object of the present invention is to manufacture $CoSi_2$/Silicon Schottky barrier detectors.

Schottky barrier infrared detectors using silicide/silicon Schottky diodes are of a high interest for applications in the range of 1 -10 μm. Among these detectors PtSi/Si Schottky IR detectors are the most developed devices with a cut-off wavelength of approximately 5 -6 μm. In these past years, $COSi_2$/Si Schottky detectors have been proposed as a promising candidate for IR applications in the range 1 -3 μm.

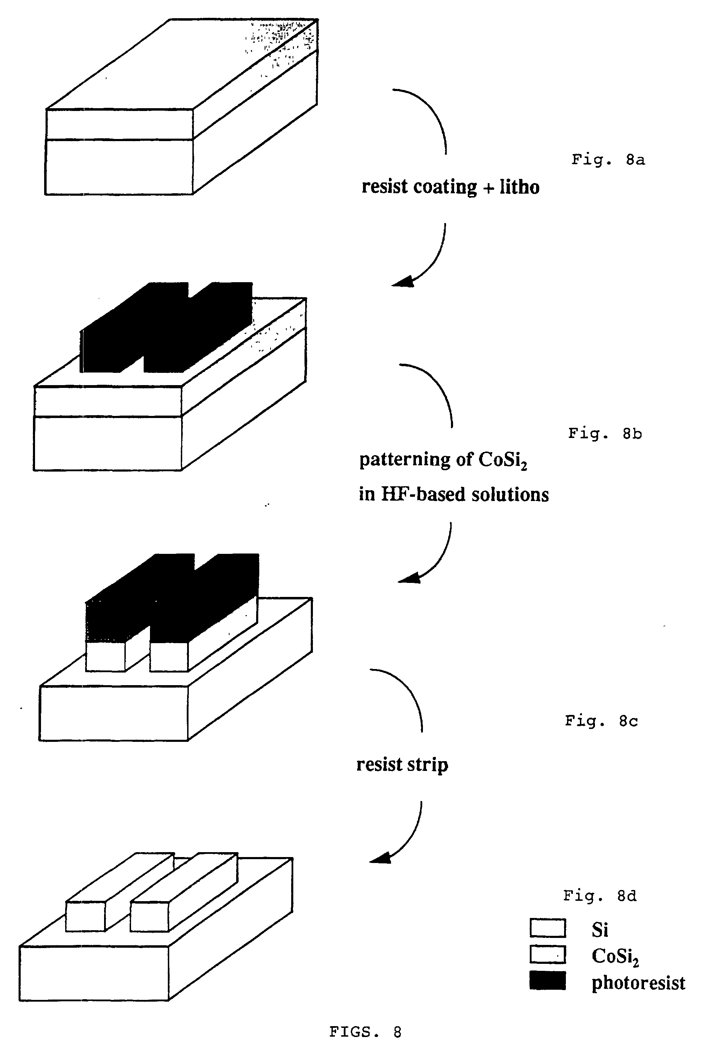

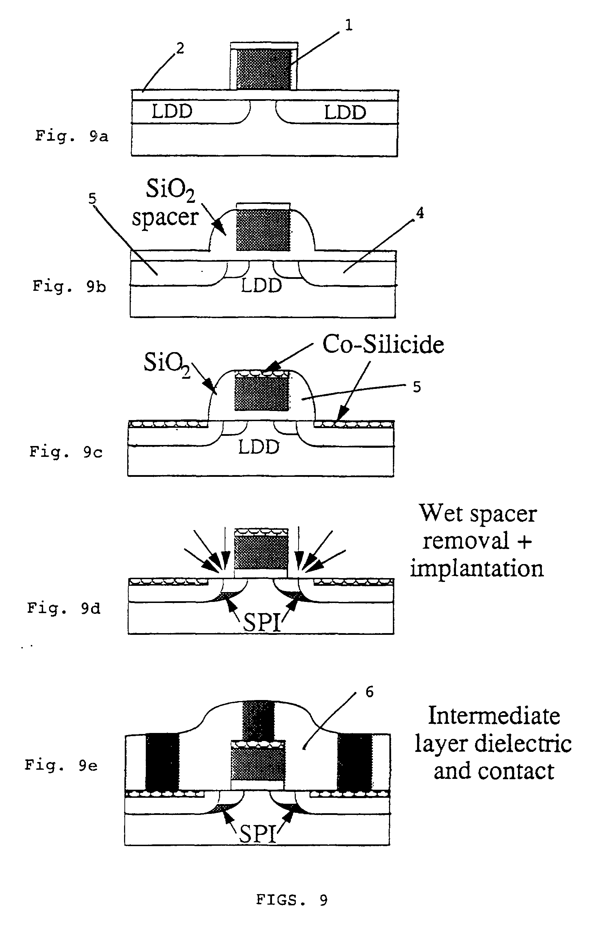

Figs. 8 more precisely represent the several steps of the etching process of a $CoSi_2$ layer strained to a Si substrate using a HF-based solution having a pH less than 1.5.

More particularly fig. 8a represents the Si substrate on which a $CoSi_2$ layer has been deposited.

Fig. 8b represents the coating of a photo-resist strip and the lithographic step in order to have a required patterning of the $CoSi_2$ layer;

Fig. 8c represents the result obtained after the wet etching in a HF-based solution of the $CoSi_2$ layer not covered by the photo-resist stip.

Fig. 8d represents the removal of the photo-resist strip leaving the required $CoSi_2$ patterning on the Si substrate.

In order to illustrate the method of etching of the $CoSi_2$ layer, the manufacture of $CoSi_2$/$Si_{1-x}Ge_x$ infrared detector is described hereunder as a preferred embodiment of this process.

This fabrication could also advantageously be integrated into CMOS processes.

For silicidation studies, lightly doped ($N_A=5x10^{16}cm-3$) p-type <100>Si wafers are used, whereas for detector experiments highly doped ($N_A=5x10^{18}cm-3$) wafers with lightly doped ($N_A=5x10^{16}cm-3$) epitaxial surface layers on top are used. Pseudomorphic $Si_{1-x}Ge_x$ layers and sacrificial Si surface layers are grown epitaxially on these samples. The deposition of the Si sacrificial layer on the SiGe layer is necessary in order to prevent any reaction of cobalt with the SiGe layer.

For the silicidation study samples, the buffer layer, the graded layer, the strained layer and the Si sacrificial layer have a thickness of 5 nm, 50 nm, 100 nm and 30 nm, respectively. For the detector samples, the thickness of the buffer layer is 5 nm, the thickness of the graded layer was 50 nm, and the thickness of the strained layer was 30 nm. The doping of the layers is p-type $10^{16}$ cm-3. The Geconcentration x is x=0.2. The sacrificial Si-layer on top is 40 nm for the detector samples and 30 nm and 100 nm for the silicidation study samples.

Before the metal deposition, the wafers are cleaned by an HF-dip d(2%). Co layers of 10 nm are deposited on the silicidation study samples and 7 nm on the detector samples. Since the silicidation conditions could not be controlled such that no reaction with strained $Si_{1-x}Ge_x$ layer could be guaranteed, the thicknesses of the sacrificial Si-layer for the detector samples are chosen to be slightly thicker than the thicknesses to be consumed by the sputtered Co thickness. Afterwards, the silicidation study samples were silicided in an AG Heatpulse rapid thermal processor system in nitrogen ambient at temperatures between 550°C and 700°C for 30 seconds. Detector samples are silicided at 600°C. After silicidation, a selective etch in $H_2SO_4/H_2O_2$ was carried out to remove the possibly remaining unreacted metal.

A $CoSi_2$/strained $Si_{1-x}Ge_x$ detector offers the big advantage that no metal leading to states that effectively reduce the minority carrier lifetime, is involved. The Si wafer has the function of the substrate. Since there is an additional layer involved, contacting the silicide becomes more difficult.

The contact to the thin $CoSi_2$ layer requires very critical etching steps and metallization steps after silicidation. Definition of the silicide areas is possible via a self-aligned silicide or also via silicide etching.

Table 1

| Composition | | | | | pH | etch rate (nm/s) |
|---|---|---|---|---|---|---|
| ml | ml | ml | | | | |
| HF 49% | H2O | | | HF2% | 1.5 | 0.22 |
| 20 | 470 | | | | | |
| | | | | | | |
| HF 49% | H2O | H2SO4 | | HF2% | | |
| 20 | 370 | 100 | | | 0 | 2.15 |
| | | | | | | |
| HF 49% | H2O | H2SO4 | | (no HF) | | |
| 0 | 390 | 100 | | | 0 | 0 |
| | | | | | | |
| HF 49% | H2O | H2SO4 | | HF2% | | |
| 20 | 460 | 10 | | | 0.5 | 0.38 |
| | | | | | | |
| HF 49% | H2O | NH4OH | | HF2% | 8.5 | 0 |
| 20 | 430 | 40 | | | | |
| | | | | | | |
| HF 49% | H2O | NH4OH | | HF2% | 3 | 0.15 |
| 20 | 450 | 20 | | | | |
| | | | | | | |
| HF 49% | H2O | NH4OH | | HF2% | 4 | 0.13 |
| 20 | 440 | 30 | | | | |
| | | | | | | |
| HF 49% | H2O | NH4OH | | HF2% | 5 | 0.1 |
| 20 | 435 | 35 | | | | |
| | | | | | | |
| HF 49% | H2O | NH4OH | | HF2% | 2.5 | 0.13 |
| 20 | 455 | 15 | | | | |
| | | | | | | |
| HF49% | H2O | HCl | | HF2% | 0.52 | 0.34 |

Table 1   (continued)

| Composition | | | | | pH | etch rate (nm/s) |
|---|---|---|---|---|---|---|
| ml | ml | ml | | | | |
| 40 | 930 | 30 | | | | |
| | | | | | | |
| HF49% | $H_2O$ | HCl | | HF2% | 0.22 | 0.38 |
| 40 | 900 | 60 | | | | |
| | | | | | | |
| HF49% | $H_2O$ | HCl | | HF2% | 0.04 | 0.42 |
| 40 | 870 | 90 | | | | |
| | | | | | | |
| HF49% | $H_2O$ | HCl | | HF2% | -0.08 | 0.47 |
| 40 | 840 | 120 | | | | |
| | | | | | | |
| HF49% | $H_2O$ | | | | | |
| 5 | 485 | | | HF0.5% | | 0.18 |
| | | | | | | |

Table 2

| Composition | | | | | pH | etch rate (nm/s) |
|---|---|---|---|---|---|---|
| ml | ml | ml | | | | |
| B-HF | | | | (from the bottle) | 4.5 | 0.045 |
| 500 | | | | | | |
| | | | | | | |
| B-HF | $H_2O$ | | | BHF 1/12.5 | 4 | 0.08 |
| 40 | 460 | | | | | |
| | | | | | | |
| B-HF | $H_2O$ | $NH_4OH$ | | BHF 1/12.5 | 6 | 0.04 |
| 40 | 450 | 10 | | | | |
| | | | | | | |
| B-HF | $H_2O$ | $H_2SO_4$ | | BHF 1/12.5 | 1.5 | 0.14 |
| 40 | 450 | 10 | | | | |
| | | | | | | |
| B-HF | $H_2O$ | | | BHF 1/7.5 | 4 | 0.07 |
| 60 | 390 | | | | | |
| | | | | | | |
| B-HF | $H_2O$ | $NH_4OH$ | | BHF 1/7.5 | 5.5 | 0.07 |
| 60 | 380 | 10 | | | | |
| | | | | | | |
| B-HF | $H_2O$ | $H_2SO_4$ | | BHF 1/7.5 | 2.5 | 0.09 |

Table 2   (continued)

| Composition | | | | | | pH | etch rate (nm/s) | | |
|---|---|---|---|---|---|---|---|---|---|
| ml | ml | ml | | | | | | | |
| 60 | 380 | 10 | | | | | | | |
| | | | | | | | | | |

**Claims**

1.  Etching process of CoSi$_2$ layers in semiconductor processing by means of a HF-based solution, **characterised in that**

    -   the etching rate of CoSi$_2$ is controlled by regulating the pH value of the HF-based solution at a value smaller than or equal to 4.0 and that
    -   the pH of the HF-based solution is regulated by adding chemicals to said solution.

2.  Etching process of CoSi$_2$ layers according to claim 1, wherein the HF-based solution is a buffered solution or not.

3.  Etching process of CoSi$_2$ layers according to claim 1 or 2, wherein the chemicals added to the HF-based solution are H$_2$SO$_4$ or HCl or NH$_4$OH.

4.  Etching process of CoSi$_2$ layers according to claim 1, wherein the pH of the HF-based solution is regulated at a pH smaller than or equal to 1.5.

5.  Process of manufacturing CoSi$_2$/Si Schottky barrier infrared detectors preferably CoSi$_2$/Si$_{1-x}$Ge$_x$ Schottky barrier infrared detectors comprising the steps of:

    -   growing a Si$_{1-x}$Ge$_x$ layer on a silicon substrate;
    -   growing a Si sacrificial layer on the top of the Si$_{1-x}$Ge$_x$ layer;
    -   depositing a Co layer on said Si sacrificial layer;
    -   heating the Co layer in order to obtain a CoSi$_2$ layer;
    -   depositing a photoresist strip on said CoSi$_2$ layer;
    -   developing the photo-resist strip using a masking layer in order to create the required patterning of the CoSi$_2$ layer;
    -   etching the CoSi$_2$ layer with a HF-based solution having a pH value smaller than 1.5;
    -   removing the photoresist strip.

**Patentansprüche**

1.  Ätzverfahren für CoSi$_2$ Schichten bei der Behandlung von Halbleitern mit Hilfe einer auf HF basierenden Lösung, **dadurch gekennzeichnet, dass** :

    -   die Ätzgeschwindigkeit von CoSi$_2$ kontrolliert wird, indem man den pH-Wert der auf HF basierenden Lösung auf einen Wert von weniger als 4,0 oder von gleich 4,0 regelt und dass

    -   der pH-Wert der auf HF basierenden Lösung durch die Zugabe von Chemikalien zu der besagten Lösung gesteuert wird.

2.  Ätzverfahren für CoSi$_2$ Schichten gemäss Anspruch 1, wobei die auf HF basierende Lösung eine gepufferte oder eine nicht gepufferte Lösung ist.

3.  Ätzverfahren für CoSi$_2$ Schichten gemäss Anspruch 1 oder 2, wobei die zu der auf HF basierenden Lösung zugegebenen Chemikalien H$_2$SO$_4$ oder HCL oder NH$_4$OH sind.

4.  Ätzverfahren für CoSi$_2$ Schichten gemäss Anspruch 1, wobei der ph-Wert der auf HF basierende Lösung auf einen pH-Wert von weniger als 4,0 oder von gleich 4,0 geregelt wird.

5. Verfahren zur Herstellung von $CoSi_2$/Si Schottky-Barriere Infrarot-Detektoren vorzugsweise von $CoSi_2$/$Si_{1-x}Ge_x$ Schottky-Barriere Infrarot-Detektoren, das die folgenden Schritte umfasst :

- Züchten einer $Si_{1-x}Ge_x$ Schicht auf einem Siliziumsubstrat;
- Züchten einer Si Opferschicht oben auf der $Si_{1-x}Ge_x$ Schicht;
- Auftragen einer Co Schicht auf der besagten Si Opferschicht;
- Erhitzen der Co Schicht, um eine $CoSi_2$ Schicht zu erzielen;
- Auftragen eines Photoresiststreifens auf der besagten $CoSi_2$ Schicht;
- Entwickeln des Photoresiststreifens unter Anwendung einer Abdeckschicht, um das erforderte Muster der $CoSi_2$ Schicht zu erzeugen;
- Ätzen der $CoSi_2$ Schicht mit einer auf HF basierenden Lösung mit einem pH-Wert von weniger als 1,5;
- Entfernen des Photoresiststreifens.

**Revendications**

1. Procédé de gravure de couches de $CoSi_2$ dans un traitement de semi-conducteurs au moyen d'une solution à base de HF, **caractérisé en ce que**:

- le taux de gravure de $CoSi_2$ est contrôlé en ajustant la valeur du pH de la solution à base de HF à une valeur inférieure ou égale à 4,0 et **en ce que**

- le pH de la solution à base de HF est ajusté en ajoutant des produits chimiques à ladite solution.

2. Procédé de gravure de couches de $CoSi_2$ selon la revendication 1, dans lequel la solution à base de HF est une solution tamponnée ou pas.

3. Procédé de gravure de couches de $CoSi_2$ selon la revendication 1 ou 2, dans lequel les produits chimiques ajoutés à la solution à base de HF sont $H_2SO_4$ ou HCl ou $NH_4OH$.

4. Procédé de gravure de couches de $CoSi_2$ selon la revendication 1, dans lequel le pH de la solution à base de HF est ajusté à un pH inférieur ou égal à 1,5.

5. Procédé de fabrication de détecteurs infrarouges à barrière de Schottky de $CoSi_2$/Si, de préférence des détecteurs infrarouges à barrière de Schottky de $CoSi_2$/$Si_{1-x}Ge_x$, comprenant les étapes:

- de croissance d'une couche de $Si_{1-x}Ge_x$ sur un substrat de silicium;

- de croissance d'une couche sacrificielle de Si au-dessus de la couche de $Si_{1-x}Ge_x$;

- de dépôt d'une couche de Co sur ladite couche sacrificielle de Si;

- de chauffage de la couche de Co dans le but d'obtenir une couche de $CoSi_2$;

- de dépôt d'une bande photorésistante sur ladite couche de $CoSi_2$;

- de développement de la bande photorésistante en utilisant une couche masquante dans le but de créer le motif requis de la couche de $CoSi_2$;

- de gravure de la couche de $CoSi_2$ avec une solution à base de HF possédant une valeur de pH inférieure à 1,5;

- de retrait de la bande photorésistante.

Fig. 1

FIG. 2

Fig. 3

Fig. 4

FIG. 5

Fig. 6

Fig. 7

13

resist coating + litho

Fig. 8a

patterning of CoSi$_2$
in HF-based solutions

Fig. 8b

resist strip

Fig. 8c

Fig. 8d

☐ Si
☐ CoSi$_2$
■ photoresist

FIGS. 8

Fig. 9a

Fig. 9b

SiO$_2$ spacer

Fig. 9c

SiO$_2$

Co-Silicide

Fig. 9d

Wet spacer removal + implantation

SPI

Fig. 9e

Intermediate layer dielectric and contact

SPI

FIGS. 9